# EUROPÄISCHE PATENTSCHRIFT

(11) **EP 3 565 074 B1**
(45) Veröffentlichungstag und Bekanntmachung des Hinweises auf die Patenterteilung: **12.04.2023**
(21) Anmeldenummer: 19171917.8
(22) Anmeldetag: 30.04.2019
(51) Int. Cl.: H02H 3/16

(54) **ANKOPPLUNGSSCHALTUNG MIT SCHALTENDER FUNKTION ZUR ANKOPPLUNG EINES ISOLATIONSÜBERWACHUNGSGERÄTES AN EIN UNGEERDETES STROMVERSORGUNGSSYSTEM**
COUPLING CIRCUIT WITH SWITCHING FUNCTION FOR COUPLING AN INSULATION MONITORING DEVICE TO AN UNGROUNDED POWER SUPPLY SYSTEM
CIRCUIT DE COUPLAGE À FONCTION DE COMMUTATION PERMETTANT DE COUPLER UN APPAREIL DE SURVEILLANCE D'ISOLATION À UN SYSTÈME D'ALIMENTATION ÉLECTRIQUE NON MIS À LA MASSE

(30) Priorität: 04.05.2018 DE 102018110709
(43) Veröffentlichungstag der Anmeldung: 06.11.2019
(73) Patentinhaber: Bender GmbH & Co. KG, 35305 Grünberg (DE)
(72) Erfinder: HERBER, Andreas, 35325 Mücke (DE); KLOSTERMANN, Joachim, 35444 Biebertal (DE)
(74) Vertreter: advotec.

(56) Entgegenhaltungen:
- EP-A2- 2 741 089
- EP-A2- 2 887 081
- WO-A1-2018/029928
- DE-A1-102010 006 108
- JP-A- 2001 284 095

## Beschreibung

Die Erfindung betrifft eine Ankopplungsschaltung mit schaltender Funktion zur Ankopplung eines Isolationsüberwachungsgerätes an ein ungeerdetes Stromversorgungssystem.

Ungeerdete Stromversorgungssysteme (IT-Systeme - frz. "Isolé Terre") werden vorwiegend in sensiblen Energieversorgungsnetzen angewendet, wo es neben dem erhöhten Schutz auch auf eine hohe Verfügbarkeit ankommt. Zu nennen wären hier beispielsweise die Anwendungsbereiche Bergbau, Energieerzeugung (Fotovoltaik und Windkraft), Kommunikationsinfrastrukturen, medizinisch genutzte Bereiche sowie Stromversorgungsnetze auf Schiffen und Offshore-Einrichtungen. Der Vorteil eines ungeerdeten Netzes besteht darin, dass bei einem Isolationsfehler, wie beispielsweise einem Erdschluss oder einem Körperschluss, die Funktion der angeschlossenen elektrischen Verbraucher nicht beeinträchtigt wird, da sich wegen des im Idealfall unendlich großen Impedanzwertes zwischen einem aktiven Leiter des Netzes und Erde kein geschlossener Stromkreis ausbilden kann. Das Netz kann also auch bei einem ersten Isolationsfehler weiter betrieben werden.

Allerdings ist der Widerstand des ungeerdeten Stromversorgungssystems gegen Erde (Isolationswiderstand - im Fehlerfall auch Isolationsfehlerwiderstand oder Fehlerwiderstand) ständig zu überwachen, da durch einen möglichen weiteren Fehler an einem anderen aktiven Leiter eine Fehlerschleife entstünde und der dabei fließende Fehlerstrom in Verbindung mit einer Überstromschutzeinrichtung eine Abschaltung der Anlage mit Betriebsstillstand zur Folge hätte. In einschlägigen Normen wird daher die Verwendung eines Isolationsüberwachungsgeräts (IMD) in dem ungeerdeten Stromversorgungssystem gefordert.

Sind mehrere ungeerdete Stromversorgungssysteme zeitweise miteinander elektrisch verbunden, ergibt sich das Problem, dass sich die einzelnen Isolationsüberwachungsgeräte gegenseitig beeinflussen können. Ein sicherer Betrieb der Isolationsüberwachungsgeräte und damit die zuverlässige Ermittlung des Isolationswiderstands sind nicht mehr gewährleistet. Um diese negative Beeinflussung zu verhindern, werden die angeschlossenen Isolationsüberwachungsgeräte bis auf eines von den miteinander gekoppelten ungeerdeten Stromversorgungssystemen getrennt. Diese Netztrennung kann durch externe oder in dem Isolationsüberwachungsgerät integrierte (Netztrenn-) Schalter erfolgen.

Im Fall eines niederohmigen Erdschlusses in einem ungeerdeten Stromversorgungssystem liegt die (Außen-) Leiterspannung (Netznennspannung) eines nicht fehlerbehafteten Leiters an dem Schalter an. Der Schalter muss somit in der Lage sein, diese Spannung sicher zu trennen.

Falls die Nennspannung eines ungeerdeten Stromversorgungssystems die Bemessungsspannung des Isolationsüberwachungsgeräts überschreitet, muss das Isolationsüberwachungsgerät mittels einer Ankoppelimpedanz an das ungeerdete Stromversorgungssystem angeschlossen werden. Dies gewährleistet, dass das Isolationsüberwachungsgerät nicht außerhalb seiner Spezifikation betrieben wird.

Ein in dem Isolationsüberwachungsgerät integrierter oder externer, zwischen Isolationsüberwachungsgerät und Ankoppelimpedanz angeordneter Schalter bildet eine Reihenschaltung mit der Ankoppelimpedanz. Bei geöffnetem Schalter ist dieser sehr hochohmig gegenüber der Ankoppelimpedanz, was dazu führt, dass die Spannung des ungeerdeten Stromversorgungssystems im Falle eines Erdschlusses nahezu vollständig über dem Schalter abfällt. Die Zerstörung des Schalters und eine Gefahr für Personen und die elektrische Anlage wären die Folge.

Auch die Ansteuerschaltung des Schalters, unabhängig davon, ob dieser mechanisch, elektromagnetisch oder elektronisch betrieben wird, muss den Potenzialunterschied zwischen dem Schalterpotenzial, welches in geschlossenem Zustand des Schalters in Folge des Spannungsabfalls über der Ankoppelimpedanz nahe dem Erdpotenzial liegt, und dem an der Ankoppelimpedanz bei geöffnetem Schalter anliegenden Potenzial, welches der Netznennspannung entspricht, überbrücken. Neben der Gefahr einer Überlastung des Schalters und der Schalteransteuerschaltung werden der schaltungstechnische Aufwand und damit die Kosten für eine solche Potenzialtrennung sehr hoch.

Aus dem Stand der Technik ist es bekannt, hochspannungstaugliche Schalter aus dem Bereich der Energieversorgung einzusetzen. Diese Schalter sind in der Lage, hohe Spannungen in Verbindung mit hohen Strömen schalten zu können. Um dies leisten zu können, sind die Schalter sehr groß und aufwändig konstruiert, was sie in der hier vorliegenden Konstellation - hohe Spannung mit geringen Strömen - überdimensioniert und deutlich zu teuer erscheinen lässt.

Alternativ dazu ist es bekannt, mechanische Schalter, zum Beispiel Reed-Relais, oder Schalter in Halbleiterbauweise zu verwenden. Relaiskontakte aber bringen die Nachteile mechanischer Schalter mit sich, die Anzahl der Schaltvorgänge ist begrenzt und ein deutlich höherer Energiebedarf zum Schalten ist erforderlich. Schalter in Halbleiterbauweise sind vorwiegend unipolar ausgeführt. Da in ungeerdeten Stromversorgungssystemen aber auch Wechselspannungen Verwendung finden, sind sie ohne weitere Schaltungsmaßnahmen nicht geeignet.

Bei einer dem Stand der Technik gemäßen Ansteuerung der Halbleiterschalter muss die Schalteransteuerung die Potenzialtrennung zwischen Halbleiterschalter-Potenzial und Ansteuerungspotenzial herstellen. Im Fall einer Ankoppelimpedanz an ein ungeerdetes Stromversorgungssystem mit einer Nennspannung von beispielsweise 6,6 kV müssten eben diese 6,6 kV von der Ansteuerschaltung überbrückt werden. Schon für diesen Spannungsbereich sind für einfache Halbleiterschalter keine Ansteuerschaltungen auf dem Markt verfügbar. Darüber hinaus würde mit zunehmender Nennspannung des ungeerdeten Stromversorgungssystems auch der Aufwand für eine Potenzialtrennung stark steigen. Insbesondere für Spannungsbereiche über 1,5 kV ist derzeit keine geschlossene Lösung verfügbar. Der Betreiber der elektrischen Anlage muss einen geeigneten Hochspannungsschalter auswählen und zwischen die Ankoppelimpedanz und das ungeerdete Stromversorgungssystem installieren oder bei spannungsfrei geschalteter elektrischer Anlage die nicht aktuell zur Messung herangezogenen Isolationsüberwachungsgeräte manuell von dem Netz trennen.

JP2001284095 offenbart einen Hochspannungsschalter.

Der vorliegenden Erfindung liegt somit die Aufgabe zugrunde, eine Vorrichtung zur Ankopplung eines Isolationsüberwachungsgerätes an ein ungeerdetes Stromversorgungssystem vorzuschlagen, welche in der Lage ist, insbesondere in Bereichen der Netznennspannung von über 1,5 kV das Isolationsüberwachungsgerät sicher von dem ungeerdeten Stromversorgungssystem zu trennen. Zudem soll unter dem Kostenaspekt auf überdimensionierte Netztrennschalter verzichtet werden können.

Diese Aufgabe wird durch eine Ankopplungsschaltung nach Anspruch 1 gelöst.

Die vorliegende Erfindung beruht somit auf der grundlegenden Idee, eine Ankopplungsschaltung modular, also bestehend aus einem oder mehreren in Reihe geschalteten, identischen Ankopplungsmodulen aufzubauen. Ist beispielsweise zwischen den aktiven Leitern und Erde eine Potenzialdifferenz von 12 kV zu überbrücken, so kann die Ankopplungsschaltung aus vier identischen Ankopplungsmodulen bestehen, die jeweils eine Potenzialdifferenz von 3 kV überbrücken.

Ein Ankopplungsmodul wiederum weist mindestens eine Schalteinheit und genau einen Übertrager auf. Bevorzugterweise ist die pro Ankopplungsmodul zu überwindende Potenzialdifferenz über mehrere in Reihe geschaltete Schalteinheiten verteilt. So kann beispielsweise die oben genannte Potenzialdifferenz von 3 kV pro Ankopplungsmodul durch drei in Reihe geschaltete Schalteinheiten verarbeitet werden, die jeweils eine Potenzialdifferenz von 1kV überwinden. Die Schalteinheit weist eine Reihenschaltung aus Ankoppelimpedanz und Schalter auf, wobei der Schalter mittels einer Ansteuerschaltung geschaltet wird. Das Ankopplungsmodul umfasst zudem genau einen Übertrager, der die Ansteuerschaltung oder die Ansteuerschaltungen mit einer Spannung versorgt. Weiterhin übernimmt der Übertrager die Aufgabe der Potenzialtrennung zwischen einem Halbleiterschalter-Potenzial und einem Ansteuerungspotenzial des als Halbleiter ausgeführten Schalters.

In dem erfindungsgemäßen modularen Aufbau umfasst jedes Ankopplungsmodul alle für den Betrieb erforderlichen schaltungstechnischen Komponenten und kann daher mit Ausnahme der Spannungsversorgung als autark betrachtet werden. Jedes Ankopplungsmodul stellt die Potenzialtrennung zu den benachbarten Ankopplungsmodulen her - also zu dem vorangeschalteten Ankopplungsmodul einer niederen Spannungs ebene und zu dem nachgeschalteten Ankopplungsmodul einer höheren Spannungsebene. Alle Ankopplungsmodule besitzen das gleiche Potenzialtrennvermögen. Durch die Reihenschaltung der Module und die sich dadurch ergebenden überbrückbaren Potenzialdifferenzen kann eine erforderliche Ankoppelimpedanz einfach an die unterschiedlichen Nennspannungen des ungeerdeten Stromversorgungssystems angepasst werden. Da jedes Ankopplungsmodul lediglich den Potenzialunterschied zu dem benachbarten Ankopplungsmodul sicherstellen muss, ist die Ansteuerung der Halbleiterschalter verhältnismäßig einfach, da keine unüberbrückbaren oder nur mit unzumutbarem Aufwand überbrückbaren Potenzialunterschiede innerhalb einer Potenzialebene vorkommen.

Der Übertrager ist eingangsseitig an ein externes Netzteil oder an einen Spannungsausgang eines Übertragers eines vorangeschalteten Ankopplungsmoduls angeschlossen und weist Spannungsausgänge auf, die zur Spannungsversorgung und Potenzialtrennung der Ansteuerschaltung bzw. der Ansteuerschaltungen sowie zur Spannungsversorgung eines weiteren Ankopplungsmoduls ausgeführt sind.

Das Ankopplungsmodul weist somit einen Übertrager auf, der entweder von einem externen Netzteil - falls das Ankopplungsmodul als Basismodul zur Überbrückung der Differenz auf niedrigster Spannungsebene eingesetzt wird - oder von dem Ausgang eines Übertragers eines vorangeschalteten Ankopplungsmoduls gespeist wird. Die übrigen Spannungsausgänge des Übertragers dienen der Spannungsversorgung der Ansteuerschaltung der jeweiligen Schalteinheiten innerhalb des Ankopplungsmoduls. Vorteilhafterweise ist die Ansteuerschaltung als eine Gleichrichterschaltung bestehend aus einer Gleichrichterdiode, einem R/C-Glied zur Glättung, einer Z-Diode zur Einstellung einer Gate-Spannung und einem Gate-Entlade-Widerstand ausgebildet.

Weitere vorteilhafte Ausgestaltungsmerkmale ergeben sich aus der nachfolgenden Beschreibung und den Zeichnungen, die eine bevorzugte Ausführungsform der Erfindung anhand von Beispielen erläutern. Es zeigen:
- **Fig. 1:**: ein ungeerdetes Stromversorgungssystem mit Isolationsüberwachungsgerät,
- **Fig. 2:**: zwei gekoppelte, ungeerdete Stromversorgungssysteme mit Isolationsüberwachungsgeräten und Ankoppelimpedanzen und
- **Fig. 3:**: ein Ausführungsbeispiel einer erfindungsgemäßen Ankopplungsschaltung mit vier Ankopplungsmodulen.

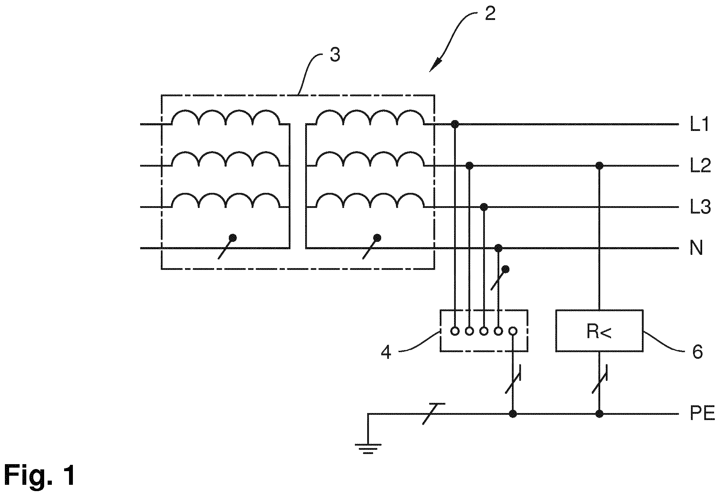

**Fig. 1** zeigt ein ungeerdetes Stromversorgungssystem in Form eines dreiphasigen Wechselspannungsnetzes mit drei aktiven Leitern L1, L2, L3 und einem Neutralleiter N. Das System wird von einer Stromquelle 3 (Transformator) gespeist und ist mit einem Verbraucher 4 belastet. Über den Schutzleiter PE ist der Körper des Verbrauchers 4 mit Erdpotenzial (Erde) verbunden.

Zur Isolationsüberwachung ist das ungeerdete Stromversorgungssystem 2 mit einem Isolationsüberwachungsgerät 6 verbunden, welches hier zwischen dem aktiven Leiter L2 und dem Schutzleiter PE angeschlossen ist.

Sinkt der Isolationswiderstand unter einen voreingestellten Wert, so wird diese Unterschreitung von dem Isolationsüberwachungsgerät 6 erkannt, und ein Alarm wird ausgegeben. Das ungeerdete Stromversorgungssystem 2 kann bei diesem ersten Fehlerfall weiterbetrieben werden, sodass der Verbraucher 4 auch weiterhin mit Strom versorgt wird.

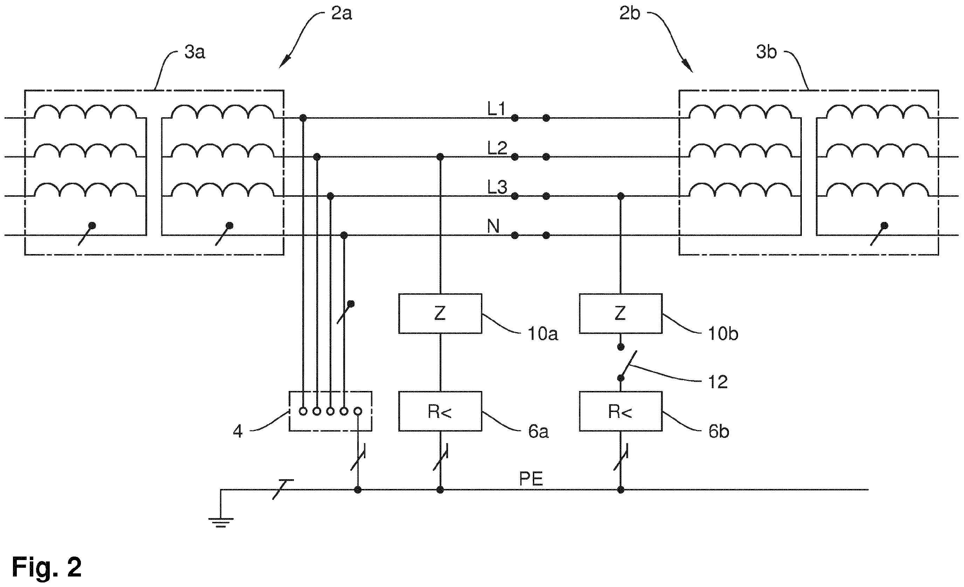

In **Fig. 2** sind zwei miteinander gekoppelte, ungeerdete Stromversorgungssysteme 2a, 2b dargestellt. Die ungeerdeten Stromversorgungssysteme 2a, 2b weisen jeweils eine eigene Stromquelle 3a, 3b auf. An die aktiven Leiter L1, L2, L3 ist der Verbraucher 4 angeschlossen, dessen Körper über den Schutzleiter PE mit Erdpotenzial verbunden ist.

Die ungeerdeten Stromversorgungssysteme 2a, 2b sind jeweils mit einem eigenen Isolationsüberwachungsgerät 6a, 6b ausgerüstet. Damit die Isolationsüberwachungsgeräte 6a, 6b hinsichtlich ihrer Bemessungsspannung innerhalb des spezifizierten Bereichs betrieben werden, ist jeweils ein Ankopplungswiderstand 10a, 10b in dem Ankopplungszweig des jeweiligen Isolationsüberwachungsgeräts 6a, 6b vorgesehen.

Um eine gegenseitige Beeinflussung bei der Isolationswiderstandsmessung zu verhindern, weist einer der Messpfade zur Isolationswiderstandsmessung einen Netztrennschalter 12 auf, mit dem das in diesem Messzweig befindliche Isolationsüberwachungsgerät von dem ungeerdeten Stromversorgungssystem 2a, 2b getrennt werden kann. In geschlossenem Zustand des Schalters liegt dieser nahezu auf Erdpotenzial - der Innenwiderstand des Isolationsüberwachungsgeräts sei vernachlässigt - muss aber bei einer Öffnung die Potenzialdifferenz zur Leiter-Erde-Spannung (im fehlerfreien Fall) oder zur Nennspannung (im Fehlerfall) des ungeerdeten Stromversorgungssystems 2a, 2b überwinden.

Wie eingangs erwähnt, sind derartige Schalter dem Stand der Technik gemäß sehr aufwändig konstruiert oder für den hier vorliegenden Fall geringer Stromstärken überdimensioniert und unverhältnismäßig teuer.

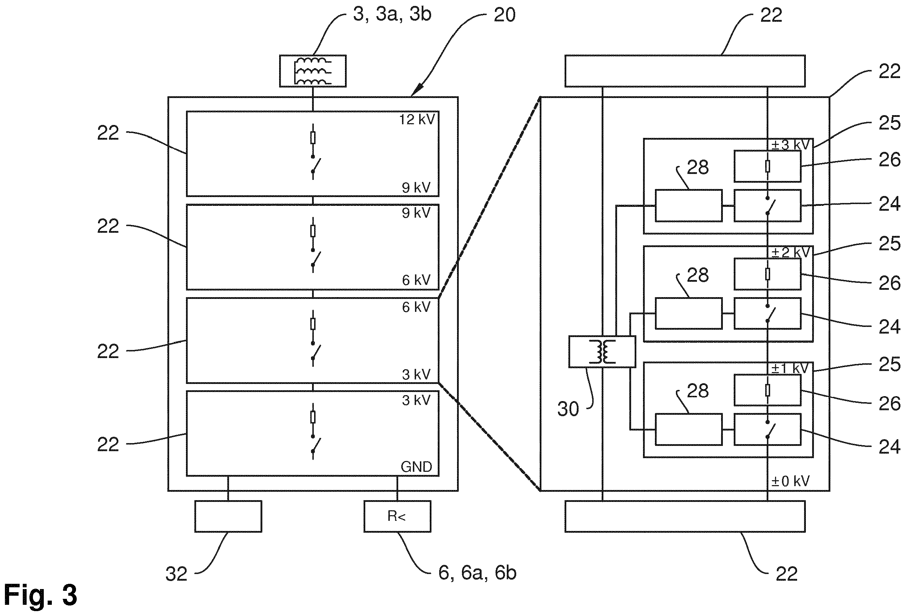

Die **Fig. 3** zeigt ein Ausführungsbeispiel einer erfindungsgemäßen Ankopplungsschaltung 20 mit vier Ankopplungsmodulen 22. Die Ankopplungsschaltung 20 wird zwischen das Isolationsüberwachungsgerät 6, 6a, 6b und das ungeerdete Stromversorgungssystem 2, 2a, 2b geschaltet. Die Ankopplungsschaltung 20 ist intern modular aufgebaut und besitzt Spannungsebenen, deren Potenzialdifferenz von vier identischen, in Reihe geschalteten Ankopplungsmodulen 22 überbrückt wird. Jedes Ankopplungsmodul 22 wiederum weist drei identische Schalteinheiten 25 auf. Jede Schalteinheit 25 umfasst eine Ankoppelimpedanz 25, einen in Reihe zu der Ankoppelimpedanz 26 angeordneten Schalter 24 und eine Ansteuerschaltung 28 zur Ansteuerung des Schalters. Das Ankopplungsmodul 22 weist weiterhin einen Übertrager 30 auf, der entweder von einem externen Netzteil 32 oder von einem Spannungsausgang eines Übertragers 30 des vorangeschalteten Ankopplungsmoduls 22 gespeist wird und dessen Spannungsausgänge die Ansteuerschaltung 28 der jeweiligen Schalteinheiten 25 des betreffenden Ankopplungsmoduls 22 speisen. Neben der Spannungsversorgung für die Ansteuerschaltungen 28 gewährleistet der Übertrager 30 auch die Potenzialtrennung zwischen den einzelnen Ankopplungsmodulen 22 sowie innerhalb der Ankopplungsmodule 22 zwischen den Schalteinheiten 25. In dem dargestellten Beispiel ist eine Potenzialdifferenz von 12 kV zu überwinden. Dies wird erreicht durch vier identische Ankopplungsmodule 22, die jeweils ein Potenzialtrennvermögen von 3 kV aufweisen. Innerhalb der Ankopplungsmodule 22 befinden sich drei Schalteinheiten 25, die jeweils eine Potenzialdifferenz von 1 kV überbrücken.

Die Schalter 24 sind mit handelsüblichen MOSFET-Halbleitern aufgebaut und so verschaltet, dass sie sowohl Gleichspannungen als auch Wechselspannungen trennen können.

Wird also der Übertrager mit Energie versorgt, so schalten alle Halbleiterschalter der Ankopplungsschaltung durch und das Isolationsüberwachungsgerät ist über die Ankoppelimpedanz mit dem IT-System verbunden. Wird der Übertrager nicht mit Energie versorgt, entladen sich die Gates der MOSFETs über die Gate-Entlade-Widerstände und die MOSFETs sperren. Das Isolationsüberwachungsgerät ist dann von dem ungeerdeten Stromversorgungssystem getrennt.

## Patentansprüche

1. Ankopplungsschaltung (20) mit schaltender Funktion zur Ankopplung eines Isolationsüberwachungsgerätes (6, 6a, 6b) an ein ungeerdetes Stromversorgungssystem (2, 2a, 2b), bestehend aus mehreren, in Reihe geschalteten, identischen Ankopplungsmodulen (22), wobei das jeweilige Ankopplungsmodul (22) mehrere Schalteinheiten (25) aufweist, die jeweils eine Ankoppelimpedanz (26), einen in Reihe zu der Ankoppelimpedanz (26) angeordneten Schalter (24) zur Trennung des Isolationsüberwachungsgerätes (6, 6a, 6b) von dem Stromversorgungssystem (2, 2a, 2b) und eine Ansteuerschaltung (28) zur Ansteuerung des Schalters (24) umfassen, und wobei das jeweilige Ankopplungsmodul (22) genau einen Übertrager (30) aufweist, der eingangsseitig an ein externes Netzteil (32) oder an einen Spannungsausgang eines Übertragers (30) eines vorangeschalteten Ankopplungsmoduls (22) der Ankopplungsmodule (22) angeschlossen ist, wobei der Übertrager (30) Spannungsausgänge zur Spannungsversorgung der Ansteuerschaltungen (28) sowie zur Spannungsversorgung eines weiteren Ankopplungsmoduls (22) der Ankopplungsmodule (22) und zur Potenzialtrennung zwischen den Ankopplungsmodulen (22) sowie innerhalb der Ankopplungsmodule (22) zwischen den Schalteinheiten (25) aufweist.

2. Ankopplungsschaltung nach Anspruch 1,
**dadurch gekennzeichnet,**
**dass** der Übertrager (30) die Spannungsausgänge aufweist, die zur Spannungsversorgung und Potenzialtrennung der Ansteuerschaltung (28)/der Ansteuerschaltungen (28) sowie zur Spannungsversorgung des weiteren Ankopplungsmoduls (22) ausgeführt sind.

3. Ankopplungsschaltung nach Anspruch 1 oder 2,
**dadurch gekennzeichnet,**
**dass** der Schalter (24) als Halbleiterschalter ausgebildet ist.

4. Ankopplungsschaltung nach einem der Ansprüche 1 bis 3,
**dadurch gekennzeichnet,**
**dass** die Ansteuerschaltung (28) als eine Gleichrichterschaltung bestehend aus einer Gleichrichterdiode, einem R/C-Glied zur Glättung, einer Z-Diode zur Einstellung einer Gate-Spannung und einem Gate-Entlade-Widerstand ausgebildet ist.

## Claims

1. A coupling circuit (20) having a switching function for coupling an insulation monitoring device (6, 6a, 6b) to an unearthed power supply system (2, 2a, 2b), the coupling circuit (20) consisting of several identical coupling modules (22) switched in series, wherein the coupling module (22) comprises several switch units (25), which each comprise a coupling impedance (26), a switch (24) which is arranged in series to the coupling impedance (26), for disconnecting the insulation monitoring device (6, 6a, 6b) from the power supply system (2, 2a, 2b) and comprises a control circuit (28) for controlling the switch (24), and wherein the corresponding coupling module (22) comprises precisely one transformer (30), which is connected at the input side to an external power supply unit (32) or to a voltage output of a transformer (30) of an upstream-connected coupling module (22) of the coupling modules, wherein the transformer (30) has voltage outputs for voltage supply of the control circuit (28) and for voltage supply of another coupling module (22) of the coupling modules (22) and for potential separation between the coupling modules (22) and within the coupling modules (22) between the switch units (22).

2. The coupling circuit according to claim 1,
**characterized in that**
the transformer (30) has the voltage outputs which are realized for voltage supply and potential separation of the control circuit (28)/the control circuits (28) and for voltage supply of the further coupling module (22).

3. The coupling circuit according to claim 1 or 2,
**characterized in that**
the switch (24) is constructed as a semiconductor switch.

4. The coupling circuit according to one of claims 1 to 3,
**characterized in that**
the control circuit (28) is constructed as a rectifier circuit consisting of a rectifier diode, an RC element for smoothing, a Zener diode for setting a gate voltage and a gate discharge resistance.

## Revendications

1. Circuit de couplage (20) ayant une fonction de commutation pour le couplage d'un contrôleur permanent d'isolement (6, 6a, 6b) à un système d'alimentation électrique (2, 2a, 2b) non mis à la terre, le circuit de couplage (20) consistant en plusieurs modules de couplage (22) identiques connectées en série, dans lequel le module de couplage (22) correspondant comprend plusieurs unités de commutation (25), qui comprennent chacune une impédance de couplage (26), un interrupteur (24) disposé en série à l'impédance de couplage (26) pour déconnecter le contrôleur permanent d'isolement (6, 6a, 6b) du système d'alimentation électrique (2, 2a, 2b) et un circuit de commande (28) pour commander l'interrupteur (24), et dans lequel le module de couplage (22) correspondant comprend exactement un transformateur (30), qui est relié au côté d'entrée à une alimentation électrique (32) extérieure ou à une sortie de tension du transformateur (30) d'une module de couplage (22) en amont des modules de couplage, dans lequel le transformateur (30) a des sorties de tension pour alimentation en tension des circuits de commande (28) et pour alimentation en tension d'un autre module de couplage (22) des modules de couplage (22) et pour séparation de potentiel entre les modules de couplage (22) et dans les modules de couplage (22) entre les unités commutation (22).

2. Circuit de couplage selon la revendication 1,
**caractérisé en ce que**
le transformateur (30) a les sorties de tension qui sont réalisées pour alimentation en tension et pour séparation de potentiel du circuit de commande (28)/ des circuits de commande (28) et pour alimentation en tension de l'autre module de couplage (22).

3. Circuit de couplage selon la revendication 1 ou la revendication 2,
**caractérisé en ce que**
l'interrupteur (24) est conçu comme interrupteur à semiconducteur.

4. Circuit de couplage selon la revendication 1 à 3,
**caractérisé en ce que**
le circuit de commande (28) est conçu comme circuit de redresseur consistant d'une diode de redressement, d'un circuit RC pour le lissage, une diode Zener pour ajuster une tension de grille et une résistance de décharge de grille.
